# EUROPEAN PATENT APPLICATION

(11) **EP 3 093 988 A1**
(43) Date of publication of application: **16.11.2016**
(21) Application number: 14877881.4
(22) Date of filing: 23.12.2014
(51) Int. Cl.: H03H 5/00, H02M 3/28

(54) **CIRCUIT CONSTANT VARIABLE CIRCUIT**

(30) Priority: 07.01.2014 JP 2014001269
(71) Applicant: Panasonic Intellectual Property Management Co., Ltd., Osaka-shi, Osaka 570-6207 (JP)
(72) Inventor: INAKAGATA, Satoru, Osaka-shi, Osaka 540-6207 (JP); TAMURA, Hideki, Osaka-shi, Osaka 540-6207 (JP); IWAHORI, Yutaka, Osaka-shi, Osaka 540-6207 (JP); NAKAZAWA, Kazushi, Osaka-shi, Osaka 540-6207 (JP); KIFUJI, Mariko, Osaka-shi, Osaka 540-6207 (JP)
(74) Representative: Appelt, Christian W.
(86) International application number: PCT/JP2014/006409
(87) International publication number: WO 2015/104769

(57) **Abstract**

This circuit constant variable circuit changes the circuit constant of a passive element for which the impedance fluctuates according to the frequency of an AC current. The circuit constant variable circuit is equipped with a first bidirectional switch (Q1) connected in series, a series circuit (20) including a passive element (C1), and a second bidirectional switch (Q2) connected in parallel to the series circuit (20).

## Description

### TECHNICAL FIELD

The present invention relates to a circuit constant variable circuit.

### BACKGROUND ART

A resonant bidirectional converter includes a primary coil and a secondary coil that are coupled to each other through electromagnetic induction. The primary coil and the secondary coil are provided with a primary drive circuit and a secondary drive circuit, respectively. The primary drive circuit and the secondary drive circuit each include a full-bridge circuit including four switching elements (Patent Document 1). When power is output from the primary side to a load of the secondary side, the full-bridge circuit of the primary drive circuit is used as a switching circuit, and the full-bridge circuit of the secondary drive circuit is used as a rectifying circuit. When power is output from the secondary side to a load of the primary side, the full-bridge circuit of the secondary drive circuit is used as a switching circuit, and the full-bridge circuit of the primary drive circuit is used as a rectifying circuit.

The resonant bidirectional converter is configured to use the same resonant frequency when the full-bridge circuit of the primary drive circuit is used as a switching circuit and when the full-bridge circuit of the secondary drive circuit is used as a switching circuit. Thus, a resonant circuit having a variable resonant parameter is connected in series to the primary coil.

More specifically, a plurality of capacitors and coils that form the resonant circuit are selected to use the same resonant frequency when the primary drive circuit is used as a switching circuit and when the secondary drive circuit is used as a switching circuit.

### PRIOR ART DOCUMENT

### PATENT DOCUMENT

Patent Document 1: Japanese Laid-Open Patent Publication No. 2012-70491

### SUMMARY OF THE INVENTION

### PROBLEMS THAT ARE TO BE SOLVED BY THE INVENTION

The above resonant circuit requires a plurality of capacitors and coils. In addition, only two resonant parameters of the resonant circuit can be selected.

It is an object of the present invention to provide a circuit constant variable circuit capable of varying a circuit constant with a simple circuit configuration.

### MEANS FOR SOLVING THE PROBLEM

One aspect of the present invention is a circuit constant variable circuit that varies a circuit constant of a passive element of which impedance changes in accordance with a frequency of an alternating current. The circuit constant variable circuit includes a series circuit including a first bidirectional switch and a passive element that are connected in series. The circuit constant variable circuit further includes a second bidirectional switch connected in parallel to the series circuit.

In the above structure, it is preferred that each of the first bidirectional switch and the second bidirectional switch include a GaN bidirectional switching device having a double-gate.

In the above structure, it is preferred that each of the first bidirectional switch and the second bidirectional switch include two series circuits, each including a diode and an IGBT that are connected in series, and that the two series circuits be connected in parallel so that the two series circuits have polarities of different directions.

In the above structure, it is preferred that each of the first bidirectional switch and the second bidirectional switch include two MOS transistors that are connected in series.

In the above structure, it is preferred that the passive element include a capacitor or a coil.

In the above structure, it is preferred that the passive element include a capacitor or a coil and that the capacitor and the coil be connected in series or in parallel.

In the above structure, it is preferred that the circuit constant variable circuit include a control circuit that causes, at least once during a single cycle of the alternating current, the first bidirectional switch to be conductive in one direction while the second bidirectional switch is non-conductive in two directions, subsequently causes the first bidirectional switch to be conductive in the other direction, and then causes the first bidirectional switch and the second bidirectional switch to be conductive in two directions.

In the above structure, it is preferred that the control circuit control a time in which the first bidirectional switch is conductive in one direction and a time in which the first bidirectional switch is conductive in the other direction.

One aspect of the present invention is a circuit constant variable circuit that varies a circuit constant of a passive element of which impedance changes in accordance with a frequency of an alternating current. The circuit constant variable circuit includes the passive element, a first bidirectional switch connected in series to the passive element, and a second bidirectional switch connected in parallel to the passive element.

In the above structure, it is preferred that each of the first bidirectional switch and the second bidirectional switch include a GaN bidirectional switching device having a double-gate.

In the above structure, it is preferred that each of the first bidirectional switch and the second bidirectional switch include two series circuits, each including a diode and an IGBT that are connected in series, and that the two series circuits be connected in parallel so that the two series circuits have polarities of different directions.

In the above structure, it is preferred that each of the first bidirectional switch and the second bidirectional switch include two MOS transistors that are connected in series.

In the above structure, it is preferred that the passive element include a capacitor or a coil.

In the above structure, it is preferred that the passive element include a capacitor and a coil that are connected in series or in parallel.

In the above structure, it is preferred that the circuit constant variable circuit include a control circuit that causes, at least once during a single cycle of the alternating current, the first bidirectional switch to be conductive in one direction while the second bidirectional switch is non-conductive in two directions, subsequently causes the first bidirectional switch to be conductive in the other direction, and then causes the first bidirectional switch and the second bidirectional switch to be conductive in two directions.

In the above structure, it is preferred that the control circuit control a time in which the first bidirectional switch is conductive in one direction and a time in which the first bidirectional switch is conductive in the other direction.

### EFFECT OF THE INVENTION

The present calorie measurement device is capable of varying the circuit constant with a simple circuit configuration.

### BRIEF DESCRIPTION OF THE DRAWINGS

Fig. 1 is an electrical circuit diagram showing a first embodiment of a circuit constant variable circuit.
Fig. 2 is an electrical circuit diagram showing a second embodiment of a circuit constant variable circuit.
Fig. 3 is an electrical circuit diagram showing an example to which a circuit constant variable circuit is applied.
Fig. 4 is an electrical circuit diagram showing an example to which a circuit constant variable circuit is applied.
Fig. 5 is an electrical circuit diagram showing another example of a bidirectional switch.
Fig. 6 is an electrical circuit diagram showing a further example of a bidirectional switch.

### EMBODIMENTS OF THE INVENTION

The present invention provides a circuit that electrically controls and varies the circuit constant of a passive element, such as the capacitance of a capacitor or the inductance of a coil, with a simplified circuit configuration.

### First Embodiment

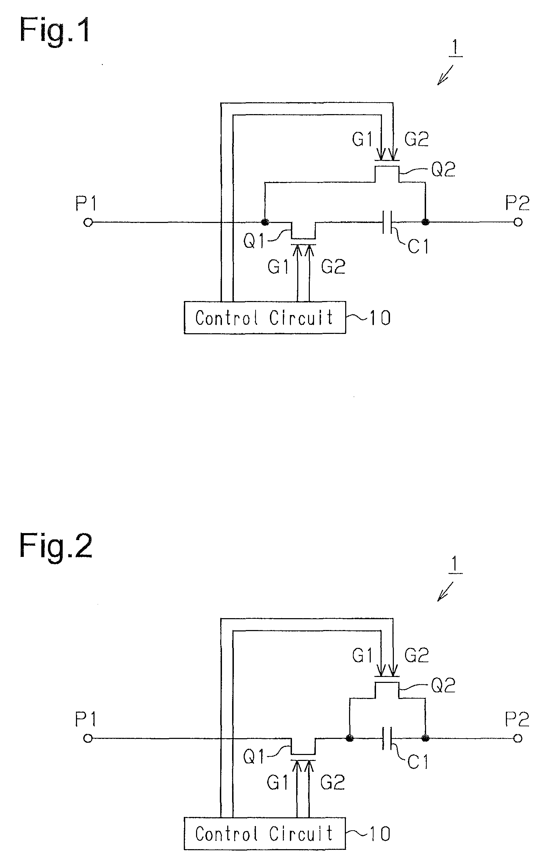

A first embodiment of a circuit constant variable circuit will now be described with reference to Fig. 1.

As shown in Fig. 1, a circuit constant variable circuit 1 includes a capacitor C1 serving as a passive element and a first bidirectional switch Q1 that are connected in series. The circuit constant variable circuit 1 further includes a second bidirectional switch Q2 that is connected in parallel to the series circuit. Alternating current is supplied to between two terminals P1 and P2 of the parallel circuit.

The bidirectional switches Q1 and Q2 each include, for example, a gallium nitride (GaN) bidirectional switching device having a double-gate that includes a first gate terminal G1 and a second gate terminal G2.

The first bidirectional switch Q1 functions in four modes that are changed by activation and deactivation signals provided to the first gate terminal G1 and the second gate terminal G2 (the same applies to second bidirectional switch Q2).

The first mode causes the first bidirectional switch Q1 (second bidirectional switch Q2) to be conductive from terminal P1 toward terminal P2 when the first gate terminal G1 is provided with the activation signal and the second gate terminal G2 is provided with the deactivation signal.

The second mode causes the first bidirectional switch Q1 (second bidirectional switch 02) to be conductive from terminal P2 toward terminal P1 when the first gate terminal G1 is provided with the deactivation signal and the second gate terminal G2 is provided with the activation signal.

The third mode causes the first bidirectional switch Q1 (second bidirectional switch Q2) to be conductive in any direction (fully conductive) between terminal P1 and terminal P2 when the first gate terminal G1 and the second gate terminal G2 are both provided with the activation signals.

The fourth mode causes the first bidirectional switch Q1 (second bidirectional switch Q2) to be non-conductive in any direction (fully non-conductive) between terminal P1 and terminal P2 when the first gate terminal G1 and the second gate terminal G2 are both provided with the deactivation signals.

A control circuit 10 is connected to the first gate terminals G1 and the second gate terminals G2 of the first and second bidirectional switches Q1 and Q2. The control circuit 10 outputs the activation and deactivation signals to the first and second gate terminals G1 and G2 of the first bidirectional switch Q1 to set the first bidirectional switch Q1 to any one of the first to fourth modes at a predetermined timing. In the same manner, the control circuit 10 outputs the activation and deactivation signals to the first and second gate terminals G1 and G2 of the second bidirectional switch Q2 to set the second bidirectional switch Q2 to any one of the first to fourth modes at a predetermined timing.

This controls the first and second bidirectional switches Q1 and Q2 to control the capacitance (circuit constant) of the capacitor C1.

The operation of the circuit constant variable circuit 1 will now be described.

The control circuit 10 controls the circuit constant variable circuit 1 by repeating steps 1 to 4, which will now be described.

### Step 1

First, the control circuit 10 sets the first bidirectional switch Q1 to the fourth mode and the second bidirectional switch Q2 to the third mode.

More specifically, the control circuit 10 outputs the deactivation signal to both of the first and second gate terminals G1 and G2 of the first bidirectional switch Q1 to deactivate the first bidirectional switch Q1 (fully non-conductive). Further, the control circuit 10 outputs the activation signal to both of the first and second gate terminals G1 and G2 of the second bidirectional switch Q2 to activate the second bidirectional switch Q2 (fully conductive).

This connects terminals P1 and P2 via the second bidirectional switch Q2.

### Step 2: Chargeable Time Control

The control circuit 10 sets the first bidirectional switch Q1 to the first mode and sets the second bidirectional switch Q2 to the fourth mode.

More specifically, the control circuit 10 outputs the activation signal to the first gate terminal G1 of the first bidirectional switch Q1 (control circuit 10 continues to output deactivation signal to second gate terminal G2) so that the first bidirectional switch Q1 is conductive from terminal P1 toward terminal P2. Further, the control circuit 10 outputs the deactivation signal to the first and second gate terminals G1 and G2 of the second bidirectional switch Q2 to deactivate the second bidirectional switch Q2 (fully non-conductive).

As a result, current flows from terminal P1 through the first bidirectional switch Q1 toward the capacitor C1 and allows the capacitor C1 to be charged.

### Step 3: Inverse-chargeable Time Control

After a predetermined chargeable time elapses, the control circuit 10 sets the first bidirectional switch Q1 to the second mode and sets the second bidirectional switch Q2 to the fourth mode.

More specifically, the control circuit 10 outputs the deactivation signal to the first gate terminal G1 of the first bidirectional switch Q1 and outputs the activation signal to the second gate terminal G2 so that the first bidirectional switch Q1 is conductive from terminal P2 toward terminal P1. Further, the control circuit 10 continues to output the deactivation signal to the first and second gate terminals G1 and G2 of the second bidirectional switch Q2 to deactivate the second bidirectional switch Q2 (fully non-conductive).

As a result, current flows from the capacitor C1 through the first bidirectional switch Q1 toward terminal P1 so that the capacitor C1 is inverse-chargeable (dischargeable).

### Step 4: Residual Electric Charge Discharging

When predetermined inverse charging results in the voltage between the terminals of the capacitor C1 becoming 0 V, the control circuit 10 sets the first bidirectional switch Q1 and the second bidirectional switch Q2 to the third mode. The timing for proceeding to step 4 may be determined based on the time in which the voltage between the terminals of the capacitor C1 becomes 0 V that is obtained through detection performed by a voltage detector or through tests, experiments, calculations, and the like that are performed in advance.

More specifically, the control circuit 10 outputs the activation signal to the first and second gate terminals G1 and G2 of the first bidirectional switch Q1 to activate the first bidirectional switch Q1 (fully conductive). Further, the control circuit 10 outputs the activation signal to the first and second gate terminals G1 and G2 of the second bidirectional switch Q2 to activate the first bidirectional switch Q1 (fully conductive).

As a result, the first and second bidirectional switches Q1 and Q2 are fully conductive so that the residual electric charge of the capacitor C1 is completely discharged.

The control circuit 10 returns to the operation of step 1 and repeats the operations of steps 1 to 4 again.

The control circuit 10 controls the operation time of steps 1 to 4, that is, the charge time and the inverse charge (discharge) time for the capacitor C1, based on the data obtained in advance through tests, experiments, calculations, and the like. This controls the accumulated amount of the electric charge in the capacitor C1 so that a virtual capacitance (circuit constant) of the capacitor C1 can be varied.

The above operations are performed once or more during a single cycle of the alternating current to control the charge time and the inverse charge time. This allows for fine variable control of the virtual capacitance (circuit constant) of the capacitor C1.

The first embodiment has the advantages described below.
(1) In the first embodiment, the virtual capacitance (circuit constant) of a single capacitor C1 is continuously variable within a wide range.
(2) In the first embodiment, the virtual capacitance (circuit constant) of the capacitor C1 can be varied with a simple structure that uses the first and second bidirectional switches Q1 and Q2 to control the charge time and the inverse charge time for the capacitor C1.

### Second Embodiment

A second embodiment of a circuit constant variable circuit will now be described with reference to Fig. 2.

As shown in Fig. 2, the circuit constant variable circuit 1 includes the capacitor C1 and the first bidirectional switch Q1 that are connected in parallel. The circuit constant variable circuit 1 further includes the second bidirectional switch Q2 that is connected in series to the parallel circuit. Alternative current is supplied to between two terminals P1 and P2 of the parallel circuit.

The bidirectional switches Q1 and Q2 each include, for example, a gallium nitride (Gan) bidirectional switching device having a double-gate that includes the first gate terminal G1 and the second gate terminal G2 in the same manner as the first embodiment.

Thus, in the same manner as the first embodiment, the first bidirectional switch Q1 and the second bidirectional switch Q2 each function in four modes that are changed by activation and deactivation signals provided to the first gate terminal G1 and the second gate terminal G2.

In the same manner as the first embodiment, the control circuit 10 is connected to the first gate terminal G1 and the second gate terminal G2 of the first and second bidirectional switches Q1 and Q2. That is, the control circuit 10 controls the first and second bidirectional switches Q1 and Q2 to control the capacitance (circuit constant) of the capacitor C1.

The operation of the circuit constant variable circuit 1 will now be described.

In the same manner as the first embodiment, the circuit constant variable circuit 1 of the second embodiment controls the capacitance (circuit constant) of the capacitor C1 by repeating steps 1 to 4. In each of the steps, the activation and deactivation signals that are output by the control circuit 10 to the first and second gate terminals G1 and G2 of the first and second bidirectional switches Q1 and Q2 are the same as the first embodiment.

Thus, in step 1, the second embodiment differs from the first embodiment only in that terminals P1 and P2 are disconnected from each other by the second bidirectional switch Q2. Thus, the remaining portions of the second embodiment will not be described.

In the second embodiment, the control circuit 10 controls the operation time of steps 2 and 3, that is, the charge time and the inverse charge time for the capacitor C1, based on the data obtained in advance through tests, experiments, calculations, and the like. This allows the control circuit 10 to control the accumulated amount of electric charge in the capacitor C1 so that a virtual capacitance (circuit constant) of the capacitor C1 can be varied.

The above operations are performed once or more during a single cycle of the alternating current to control the charge time and the discharge time. This allows for fine variable control of the virtual capacitance (circuit constant) of the capacitor C1.

The second embodiment has the advantages described below.
(1) In the second embodiment, the virtual capacitance (circuit constant) of a single capacitor C1 is continuously variable within a wide range.
(2) In the second embodiment, the virtual capacitance (circuit constant) of the capacitor C1 can be varied with a simple structure that uses the first and second bidirectional switches Q1 and Q2 to control the charge time and the inverse charge time for the capacitor C1.

The first and second embodiments may be changed as described below.

The circuit constant variable circuit 1 of the first and second embodiments may be applied to a resonant circuit used for an electromagnetically inductive coupling circuit such as a contactless power supplying system.

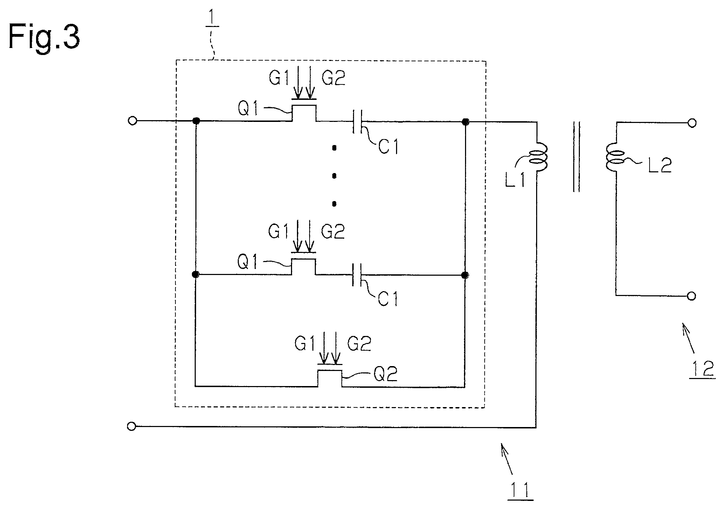

For example, as shown in Fig. 3, a primary coil L1 of a primary circuit 11 is coupled to a secondary coil of a secondary circuit 12 through electromagnetic induction. The circuit constant variable circuit 1 serving as a resonant circuit is connected to the primary coil L1.

The circuit constant variable circuit 1 includes series circuits that are connected in parallel. Each of the series circuits includes the capacitor C1 and the first bidirectional switch Q1 that are connected in series. The circuit constant variable circuit 1 further includes the second bidirectional switch Q2 that is connected in parallel to the series circuits that are connected in parallel.

The first bidirectional switch Q1 of each series circuit and the second bidirectional switch Q2, which is connected in parallel to the series circuits, are set to each mode so that the capacitance of the circuit constant variable circuit 1, that is, the capacitance (resonant parameter) of the resonant circuit, can be varied.

In Fig. 3, the series circuits, each including the capacitor C1 and the first bidirectional switch Q1, are connected in parallel. Instead, the circuit constant variable circuit 1 may include a single series circuit as described in the first embodiment.

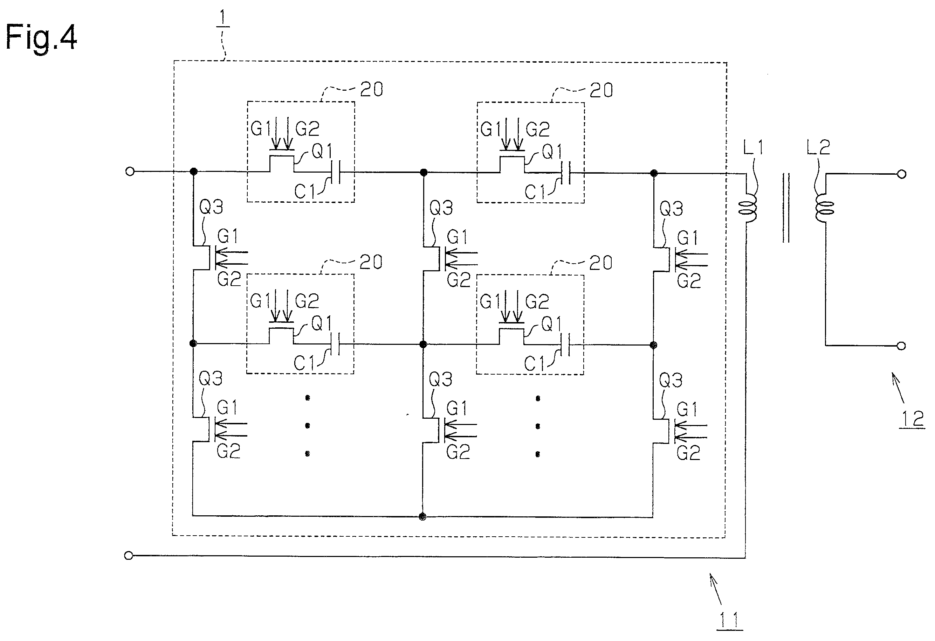

Further, as shown in Fig. 4, series circuits 20 may each include the capacitor C1 and the first bidirectional switch Q1, and the series circuits 20 may be connected to one another by a third bidirectional switch Q3 so as to form a ladder. In such a case, the circuit constant variable circuit 1 may be used as a resonant circuit of the primary circuit 11.

The first bidirectional switches Q1 of the series circuits 20 and the third bidirectional switches Q3, which connect the first bidirectional switches Q1 to one another, are set to each mode so that the capacitance of the circuit constant variable circuit 1, that is, the capacitance (resonant parameter) of the resonant circuit, can be varied.

In Figs. 3 and 4, the circuit constant variable circuit 1 is used as a resonant circuit of the primary circuit 11. Instead, the circuit constant variable circuit 1 may be used as a resonant circuit of the secondary circuit 12.

The circuit constant variable circuit 1 of each of the embodiments includes the capacitor C1 serving as a passive element. Instead, the capacitor C1 may be replaced with a coil that serves as a passive element. This allows the virtual inductance (circuit constant) of a single coil to be continuously variable within a wide range. Further, the virtual inductance (circuit constant) of the coil can be varied with a simple structure that controls the first and second bidirectional switches Q1 and Q2.

In each of the embodiments, the passive element may include a capacitor and a coil, and the capacitor and the coil may be connected in series or parallel. Even in this case, the capacitance (circuit constant) of the capacitor and the capacitance (circuit constant) of the coil can be varied.

In each of the embodiments, the first and second bidirectional switches Q1 and Q2 each include a nitrogen gallium (Gan) bidirectional switching device having a double-gate that includes the first gate terminal G1 and the second gate terminal G2.

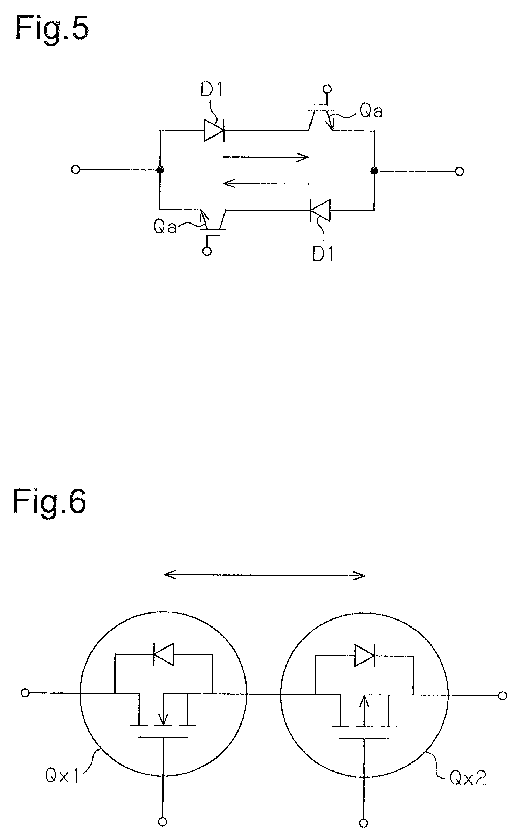

Instead, as shown in Fig. 5, the bidirectional switches Q1 and Q2 may each include two series circuits, and each of the two series circuits may include a diode D1 and an insulated-gate bipolar transistor Qa (IGBT) that are connected in series. The two series circuits are connected in parallel so that the two series circuits have polarities of different directions.

In addition, as shown in Fig. 6, the bidirectional switches Q1 and Q2 may each include an N-channel power MOS transistor Qx1 and a P-channel power MOS transistor Qx2 that are connected in series.

## Claims

1. A circuit constant variable circuit that varies a circuit constant of a passive element of which impedance changes in accordance with a frequency of an alternating current, the circuit constant variable circuit comprising:
a series circuit including a first bidirectional switch and a passive element that are connected in series; and
a second bidirectional switch connected in parallel to the series circuit.

2. The circuit constant variable circuit according to claim 1, wherein each of the first bidirectional switch and the second bidirectional switch includes a GaN bidirectional switching device having a double-gate.

3. The circuit constant variable circuit according to claim 1, wherein
each of the first bidirectional switch and the second bidirectional switch includes two series circuits, each including a diode and an IGBT that are connected in series, and
the two series circuits are connected in parallel so that the two series circuits have polarities of different directions.

4. The circuit constant variable circuit according to claim 1, wherein each of the first bidirectional switch and the second bidirectional switch includes two MOS transistors that are connected in series.

5. The circuit constant variable circuit according to any one of claims 1 to 4, wherein the passive element includes a capacitor or a coil.

6. The circuit constant variable circuit according to any one of claims 1 to 4, wherein
the passive element includes a capacitor and a coil, and
the capacitor and the coil are connected in series or in parallel.

7. The circuit constant variable circuit according to any one of claims 1 to 6, comprising a control circuit that causes, at least once during a single cycle of the alternating current, the first bidirectional switch to be conductive in one direction while the second bidirectional switch is non-conductive in two directions, subsequently causes the first bidirectional switch to be conductive in the other direction, and then causes the first bidirectional switch and the second bidirectional switch to be conductive in two directions.

8. The circuit constant variable circuit according to claim 7, wherein the control circuit controls a time in which the first bidirectional switch is conductive in one direction and a time in which the first bidirectional switch is conductive in the other direction.

9. A circuit constant variable circuit that varies a circuit constant of a passive element of which impedance changes in accordance with a frequency of an alternating current, the circuit constant variable circuit comprising:
the passive element;
a first bidirectional switch connected in series to the passive element; and
a second bidirectional switch connected in parallel to the passive element.

10. The circuit constant variable circuit according to claim 9, wherein each of the first bidirectional switch and the second bidirectional switch includes a GaN bidirectional switching device having a double-gate.

11. The circuit constant variable circuit according to claim 9, wherein
each of the first bidirectional switch and the second bidirectional switch includes two series circuits, each including a diode and an IGBT that are connected in series, and
the two series circuits are connected in parallel so that the two series circuits have polarities of different directions.

12. The circuit constant variable circuit according to claim 9, wherein each of the first bidirectional switch and the second bidirectional switch includes two MOS transistors that are connected in series.

13. The circuit constant variable circuit according to any one of claims 9 to 12, wherein the passive element includes a capacitor or a coil.

14. The circuit constant variable circuit according to any one of claims 9 to 12, wherein
the passive element includes a capacitor and a coil that are connected in series or in parallel.

15. The circuit constant variable circuit according to any one of claims 9 to 14, comprising a control circuit that causes, at least once during a single cycle of the alternating current, the first bidirectional switch to be conductive in one direction while the second bidirectional switch is non-conductive in two directions, subsequently causes the first bidirectional switch to be conductive in the other direction, and then causes the first bidirectional switch and the second bidirectional switch to be conductive in two directions.

16. The circuit constant variable circuit according to claim 15, wherein the control circuit controls a time in which the first bidirectional switch is conductive in one direction and a time in which the first bidirectional switch is conductive in the other direction.

## Amended claims

### Amended claims under Art. 19.1 PCT

1. A circuit constant variable circuit that varies a circuit constant of a passive element of which impedance changes in accordance with a frequency of an alternating current, the circuit constant variable circuit comprising:
a series circuit including a first bidirectional switch and a passive element that are connected in series;
a second bidirectional switch connected in parallel to the series circuit; and
a control circuit that causes, at least once during a single cycle of the alternating current, the first bidirectional switch to be conductive in one direction while the second bidirectional switch is non-conductive in two directions and subsequently causes the first bidirectional switch to be conductive in the other direction.

2. The circuit constant variable circuit according to claim 1, wherein each of the first bidirectional switch and the second bidirectional switch includes a GaN bidirectional switching device having a double-gate.

3. The circuit constant variable circuit according to claim 1, wherein
each of the first bidirectional switch and the second bidirectional switch includes two series circuits, each including a diode and an IGBT that are connected in series, and
the two series circuits are connected in parallel so that the two series circuits have polarities of different directions.

4. The circuit constant variable circuit according to claim 1, wherein each of the first bidirectional switch and the second bidirectional switch includes two MOS transistors that are connected in series.

5. The circuit constant variable circuit according to any one of claims 1 to 4, wherein the passive element includes a capacitor or a coil.

6. The circuit constant variable circuit according to any one of claims 1 to 4, wherein
the passive element includes a capacitor and a coil, and
the capacitor and the coil are connected in series or in parallel.

7. The circuit constant variable circuit according to any one of claims 1 to 6, wherein the control circuit causes, at least once during a single cycle of the alternating current, the first bidirectional switch to be conductive in one direction while the second bidirectional switch is non-conductive in two directions, subsequently causes the first bidirectional switch to be conductive in the other direction, and then causes the first bidirectional switch and the second bidirectional switch to be conductive in two directions.

8. The circuit constant variable circuit according to any one of claims 1 to 7, wherein the control circuit controls a time in which the first bidirectional switch is conductive in one direction and a time in which the first bidirectional switch is conductive in the other direction.

9. A circuit constant variable circuit that varies a circuit constant of a passive element of which impedance changes in accordance with a frequency of an alternating current, the circuit constant variable circuit comprising:
the passive element;
a first bidirectional switch connected in series to the passive element;
a second bidirectional switch connected in parallel to the passive element; and
a control circuit that causes, during a single cycle of the alternating current, the first bidirectional switch to be conductive in one direction while the second bidirectional switch is non-conductive in two directions and subsequently causes the first bidirectional switch to be conductive in the other direction.

10. The circuit constant variable circuit according to claim 9, wherein each of the first bidirectional switch and the second bidirectional switch includes a GaN bidirectional switching device having a double-gate.

11. The circuit constant variable circuit according to claim 9, wherein
each of the first bidirectional switch and the second bidirectional switch includes two series circuits, each including a diode and an IGBT that are connected in series, and
the two series circuits are connected in parallel so that the two series circuits have polarities of different directions.

12. The circuit constant variable circuit according to claim 9, wherein each of the first bidirectional switch and the second bidirectional switch includes two MOS transistors that are connected in series.

13. The circuit constant variable circuit according to any one of claims 9 to 12, wherein the passive element includes a capacitor or a coil.

14. The circuit constant variable circuit according to any one of claims 9 to 12, wherein
the passive element includes a capacitor and a coil that are connected in series or in parallel.

15. The circuit constant variable circuit according to any one of claims 9 to 14, wherein the control circuit causes, at least once during a single cycle of the alternating current, the first bidirectional switch to be conductive in one direction while the second bidirectional switch is non-conductive in two directions, subsequently causes the first bidirectional switch to be conductive in the other direction, and then causes the first bidirectional switch and the second bidirectional switch to be conductive in two directions.

16. The circuit constant variable circuit according to any one of claims 9 to 15, wherein the control circuit controls a time in which the first bidirectional switch is conductive in one direction and a time in which the first bidirectional switch is conductive in the other direction.
Brief statement under article 19(1)
Claims 1 and 9 have been amended based on claims 7 and 15 that have a novelty and an inventive step. This identify that amended claims 1 and 9 comprise "a control circuit that causes, at least once during a single cycle of the alternating current, the first bidirectional switch to be conductive in one direction while the second bidirectional switch is non-conductive in two directions and subsequently causes the first bidirectional switch to be conductive in the other direction" None of cited references 1-6 disclose and suggest that "a control circuit that causes, at least once during a single cycle of the alternating current, the first bidirectional switch to be conductive in one direction while the second bidirectional switch is non-conductive in two directions and subsequently causes the first bidirectional switch to be conductive in the other direction."
